# DEMANDE DE BREVET EUROPEEN

(11) **EP 3 422 573 A1**
(43) Date de publication de la demande: **02.01.2019**
(21) Numéro de dépôt: 18177782.2
(22) Date de dépôt: 14.06.2018
(51) Int. Cl.: H03K 3/0233, H03K 5/1252

(54) **COMPARATEUR NON OSCILLANT**

(30) Priorité: 28.06.2017 FR 1755922
(71) Demandeur: STMicroelectronics (Grenoble 2) SAS, 38000 Grenoble (FR); STMicroelectronics (Rousset) SAS, 13790 Rousset (FR)
(72) Inventeur: BINET, Vincent, 13100 AIX EN PROVENCE (FR); CHESNEAU, David, 38140 RENAGE (FR)
(74) Mandataire: Casalonga

(57) **Abrégé**

Comparateur (COMP) comprenant une interface d'entrée (E1, Eref) pour recevoir des signaux d'entrée (s1, s2), une interface de sortie (S_{COMP}) pour délivrer un signal de sortie (S_{COMP}), des moyens de comparaison (100) couplés entre l'interface d'entrée et l'interface de sortie, des moyens d'amplification (1,2) connectés entre l'interface d'entrée (E1, Eref) et les moyens de comparaison (100), et des moyens de neutralisation (200) configurés pour neutraliser tout changement d'état du signal de sortie à compter de chaque instant de changement d'état du signal de sortie pendant une deuxième durée de propagation (Tpe) égale à une durée de propagation de signaux à l'intérieur des moyens d'amplification (1, 2).

## Description

Des modes de réalisation de l'invention concernent les dispositifs comparateur, et notamment les dispositifs comparateur haute fréquence utilisés dans les alimentations à découpage, par exemple pour le contrôle de moteurs électriques, de chargeurs de batterie, de dispositifs d'éclairage.

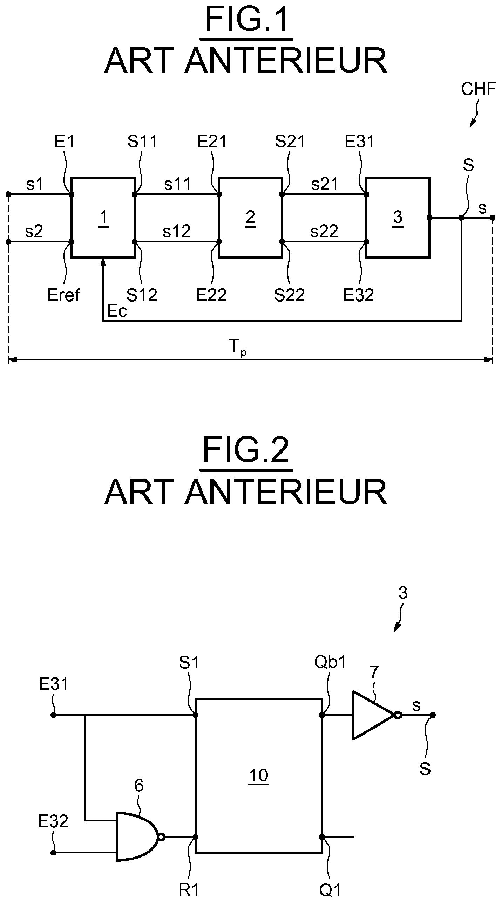

La figure 1 représente un exemple de comparateur CHF selon l'état de la technique.

Le comparateur CHF comprend une interface d'entrée comprenant les bornes d'entrée E1 et Eref et interface de sortie comprenant une borne de sortie S.

Il comprend en outre des moyens d'amplification comprenant un dispositif préamplificateur 1 et un amplificateur de gain identifié par la référence numérique 2.

Le dispositif préamplificateur 1 comprend des entrées reliées aux bornes E1 et Eref et des sorties S11 et S12 reliées respectivement à des entrées E21 et E22 du dispositif amplificateur de gain 2.

Le comparateur CHF comprend un étage verrou 3 (« latch » en anglais) comprenant des bornes d'entrée E31 et E32 reliées respectivement à des sorties S21 et S22 du dispositif amplificateur de gain 2. L'étage verrou 3 comprend une borne de sortie S.

Le dispositif préamplificateur 1 comprend en outre une entrée de commande Ec reliée à la borne S.

La borne E1 est destinée à recevoir un signal s1 et la borne Eref est destinée à recevoir un signal de référence s2, et la borne S est destinée à recevoir un signal s. La fréquence de fonctionnement du comparateur CHF est par exemple de l'ordre de 200 MHz correspondant à une première durée de propagation Tp de 5 ns des signaux s1 et s2 aux entrées E1 et Eref jusqu'à la sortie S du comparateur CHF.

Le dispositif préamplificateur 1 comprend des amplificateurs opérationnels fonctionnant dans leur zone de linéarité, proche de leur point d'équilibre et un dispositif d'hystérésis commandé par l'entrée Ec.

Les sorties S11 et S12 délivrent des signaux s11 et s12.

Le dispositif amplificateur 2 comprend généralement plusieurs étages d'amplification reliés en cascade comprenant chacun plusieurs amplificateurs opérationnels fonctionnant dans leur zone de linéarité. Les amplificateurs opérationnels sont généralement reliés d'après le schéma montage inverseur connu de l'homme du métier.

Les sorties S21 et S22 délivrent des signaux s21 et s22.

L'étage verrou 3 comprend généralement une bascule dont une première entrée est reliée à l'entrée E31 et une seconde entrée est reliée à l'entrée E32. Les signaux s21 et s22 sont appliqués aux entrées E31 et E32.

La figure 2 illustre un exemple d'étage verrou 3 selon l'état de la technique.

Il comprend un dispositif 10 de bascule comprenant une première entrée de forçage S1 d'une première sortie Q1 et une deuxième entrée de forçage R1 d'une deuxième sortie Qb1.

Le dispositif 10 de bascule comprend une bascule, par exemple une bascule du type RS.

Lorsque l'entrée de forçage S1 est activée, la sortie Q1 est un « 1 » logique et la sortie Qbl est égale à « 0 ». Lorsque l'entrée de forçage R1 est activée, la sortie Qb1 est un « 1 » logique et la sortie Q1 est égale à « 0 ».

Lorsque les entrées S1 et R1 sont simultanément activées, les sorties Q1 et Qbl conservent leur état précédant le changement d'état des entrées S1 et R1.

L'entrée S1 du dispositif 10 de bascule est reliée à la borne E31, l'entrée R1 du dispositif 10 de bascule est reliée à la sortie d'une porte logique NON-ET 6 comportant deux entrées dont une première entrée est reliée à la borne E31 et la deuxième entrée est reliée à la borne E32. La sortie Qbl du dispositif 10 est reliée à l'entrée d'une porte logique inverseuse 7. La sortie de la porte logique 7 est reliée à la borne de sortie S.

Selon la valeur relative des signaux s1 et s2, la bascule délivre un signal s égal à un « 1 » logique à la borne de sortie S si s1 est supérieur à s2, dans le cas contraire le signal s est égal à un « 0 » logique.

L'étage verrou 3 compare, d'une part, les signaux s21 et s22, et d'autre part, convertit le signal résultant de la comparaison des signaux s21 et s22 en un signal numérique s à la borne S.

Afin de réagir rapidement aux faibles variations du signal d'entrée s1, le comparateur haute fréquence CHF a un gain élevé et une bande passante élevée.

Les signaux s1 et s2 sont par exemple amplifiés par les dispositifs 1 et 2 d'un gain d'environ 100 dB.

Cette valeur de la sortie S est transmise à l'entrée Ec.

Comme les dispositifs 1 et 2 fonctionnent près de leur point d'équilibre, une variation très faible de l'une de leurs entrées peut faire basculer le signal s.

Par conséquent un bruit dans le comparateur CHF peut faire varier la sortie de l'étage verrou 3 et ainsi l'état logique de la borne de sortie S du comparateur CHF.

Comme le bruit est par définition aléatoire, le signal s se met à osciller en délivrant une succession de 0 et 1 logiques sans que les signaux entrées s1 et s2 du comparateur CHF ne varient.

Le dispositif d'hystérésis incorporé dans le préamplificateur 1 supprime la survenue des oscillations causées par un bruit en modifiant à chaque changement d'état du signal de sortie s du comparateur CHF la valeur du signal s1. Il ajoute ou retranche une valeur de décalage Vdec au signal s1 à chaque changement d'état du signal s. Cette valeur de décalage est ajoutée à s1 si le signal de sortie s est égal à 1 ou retranchée de s1 si le signal de sortie s est égal à 0. Cette valeur fixe est connue sous la dénomination de valeur d'hystérésis. Ce décalage de la valeur du signal s1 évite que la sortie S du comparateur ne bascule à chaque variation du signal de comparaison inférieure ou supérieure à la valeur Vdec prédéfinie.

Cependant, lorsque les oscillations résultant du bruit sont sensiblement de même période ou de période inférieure à celle de la première durée de propagation Tp des signaux à travers le comparateur CHF, par exemple de l'ordre de 5 ns, le signal s11 comportant la valeur de décalage n'a pas le temps de se propager dans le comparateur CHF. La sortie S du comparateur se met alors à osciller.

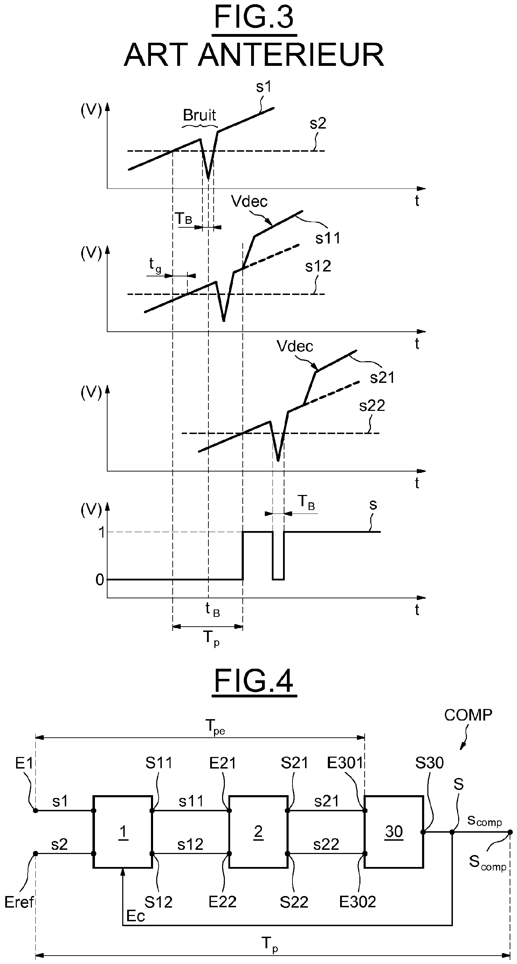

La figure 3 illustre le fonctionnement du comparateur CHF soumis à un bruit sur son entrée E1.

Les signaux en sortie des dispositifs 1 et 2 présentent un retard égal à la durée de propagation des signaux dans lesdits dispositifs, par exemple le dispositif préamplificateur 1 présente une durée de propagation tg.

Les variations du signal s par rapport au signal de sortie s1 du comparateur CHF présentent un retard égal à la première durée de propagation Tp. Par conséquent la valeur d'hystérésis Vdec est appliquée sur le signal s11 à l'instant du croisement des signaux s1 et s2 majoré de la première durée Tp. Un bruit apparaît à l'instant t_{B} pendant une durée T_{b} inférieure à la première durée de propagation Tp. Par conséquent l'hystérésis s'active après le passage de la perturbation dans le comparateur CHF. On observe une variation du signal s pendant une durée Tb. L'hystérésis n'a pas permis d'immuniser le bruit au comparateur.

Des dispositifs de filtrage, notamment des filtres numériques placés en sortie du comparateur permettent de filtrer les oscillations.

Cependant les dispositifs de filtrage nécessitent des horloges supplémentaires de fréquence plus élevée que celle de la fréquence de fonctionnement du comparateur pour éviter des temps de latence de la sortie du comparateur, et des circuits supplémentaires.

Ces éléments supplémentaires entraînent une consommation additionnelle de l'ordre de deux fois la consommation du comparateur CHF, et complexifient le comparateur.

Il existe par conséquent un besoin de supprimer les oscillations causées par le bruit dans un comparateur, en particulier un comparateur haute fréquence, sans introduire de retard dans le signal de sortie du comparateur et en maîtrisant sa consommation électrique.

Selon un aspect, il est proposé un procédé de contrôle du fonctionnement d'un comparateur comportant des moyens d'amplification connectés en entrée de moyens de comparaison, le procédé comportant une neutralisation de tout changement d'état d'un signal de sortie du comparateur à compter de chaque instant de changement d'état du signal de sortie et pendant une seconde durée de propagation égale à une durée de propagation de signaux à l'intérieur des moyens d'amplification.

Selon un autre aspect, il est proposé un comparateur comprenant une interface d'entrée pour recevoir des signaux d'entrée, une interface de sortie pour délivrer un signal de sortie, des moyens de comparaison couplés entre l'interface d'entrée et l'interface de sortie, des moyens d'amplification connectés entre l'interface d'entrée et les moyens de comparaison, et des moyens de neutralisation configurés pour neutraliser tout changement d'état du signal de sortie à compter de chaque instant de changement d'état du signal de sortie pendant une deuxième durée de propagation égale à une durée de propagation de signaux à l'intérieur des moyens d'amplification.

La seconde durée de propagation est par exemple égale à une première durée de propagation égale à une durée de propagation de signaux à l'intérieur du comparateur à une tolérance près.

La tolérance est par exemple comprise entre 0 et 5%.

Selon un autre mode de mise en oeuvre, les moyens de neutralisation comportent un circuit de réplique des moyens d'amplification configurés pour présenter la deuxième durée de propagation.

La durée de propagation des signaux est dépendante de plusieurs paramètres du comparateur qui varient fréquemment, le circuit réplique permet de tenir compte de ces variations contrairement à une valeur prédéterminée fixe qui a été déterminée pour un jeu de paramètres.

Les moyens de comparaison comportent par exemple un étage verrou couplé à l'interface de sortie et les moyens de neutralisation sont couplés à l'étage verrou.

Selon encore un mode de réalisation, l'étage verrou comporte une bascule couplée à l'interface de sortie par l'intermédiaire d'un multiplexeur et les moyens de neutralisation sont couplés entre les sorties et les entrées de la bascule.

Selon un mode de réalisation, les moyens de neutralisation comportent le circuit de réplique possédant des entrées couplées aux entrées de la bascule et des portes logiques couplées entre des sorties du circuit de réplique et les entrées de la bascule.

Selon encore un mode de réalisation les moyens d'amplification comportent des amplificateurs opérationnels et le circuit de réplique comporte des amplificateurs opérationnels auxiliaires fonctionnellement analogues aux amplificateurs opérationnels à un facteur d'échelle près.

Le circuit de réplique reprend ainsi par exemple l'architecture des moyens d'amplification en la simplifiant de façon à diminuer sa consommation électrique et à réduire la surface occupée par celui-ci.

Le comparateur présente par exemple une fréquence de fonctionnement supérieure à 200 MHz, la période associée à cette fréquence étant égale à la durée de propagation du signal à travers le comparateur.

D'autres avantages et caractéristiques de l'invention apparaîtront à l'examen de la description détaillée de modes de réalisation, nullement limitatifs, et de dessins annexés sur lesquels :
- les figures 1 à 3, précédemment décrites, illustrent des modes de réalisation d'un comparateur selon l'invention ; et
- les figures 4 à 7 illustrent différents modes de réalisation et de mise en oeuvre de l'invention.

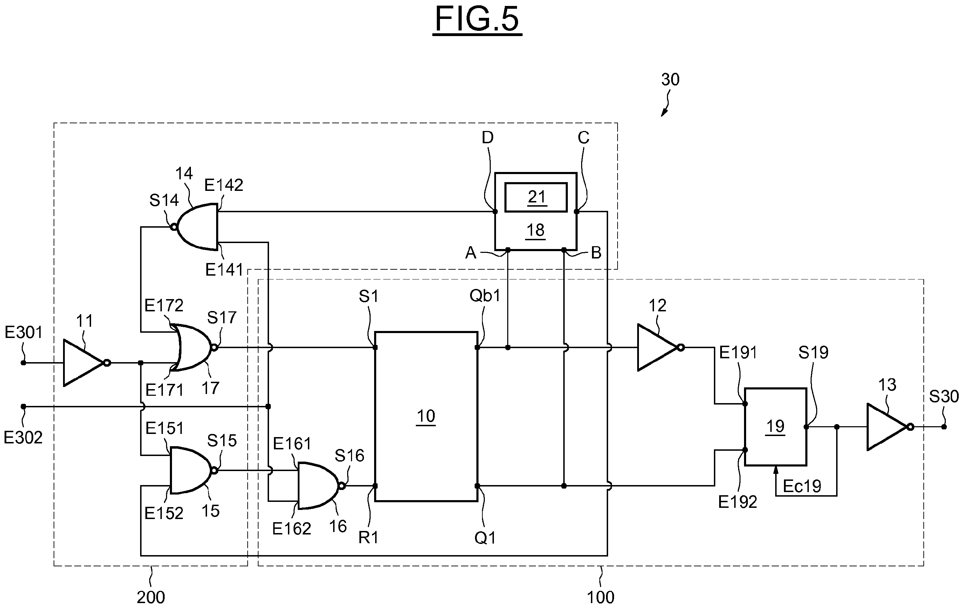

On se réfère aux figures 4 et 5 qui représentent un exemple de mode de réalisation d'un comparateur COMP et d'un étage verrou 30.

On retrouve l'interface d'entrée comprenant les bornes E1 et Eref recevant les signaux s1 et s2 d'entrée, les moyens d'amplification comprenant le dispositif préamplificateur 1 et le dispositif amplificateur 2 reliés entre eux comme décrit précédemment.

Le comparateur COMP comprend en outre une interface de sortie comprenant une borne S_{COMP} pour délivrer un signal de sortie s_{COMP} et un étage verrou 30 comprenant une première borne d'entrée E301 reliée à la sortie S21, une deuxième borne d'entrée E302 reliée à la sortie S22 et une borne de sortie S30 reliée à la borne de sortie S_{COMP} du comparateur COMP, et d'autre part, à l'entrée Ec du dispositif préamplificateur 1.

Avantageusement le comparateur COMP est un exemple de comparateur haute fréquence dont la première durée de propagation Tp des signaux s1 et s2 aux entrées E1 et Eref est par exemple inférieure à 5 ns. La fréquence F de fonctionnement du comparateur COMP est égale à l'inverse de la première durée de propagation Tp, par conséquent le comparateur COMP présente une fréquence de fonctionnement supérieure à 200 MHz.

Le comparateur COMP comporte des moyens de comparaison 100 couplés entre l'interface d'entrée et l'interface de sortie comportant l'étage verrou 30 couplé à l'interface de sortie et des moyens de neutralisation 200 configurés pour neutraliser tout changement d'état du signal de sortie s_{COMP} à compter de chaque instant de changement d'état du signal de sortie s_{COMP} pendant une durée égale à une deuxième durée de propagation Tpe de signaux dans le comparateur en amont des moyens de comparaison 100 et de neutralisation 200 à une tolérance près.

La durée de propagation des signaux dans les moyens de comparaison 100 et les moyens de neutralisation 200 est négligeable par rapport à la durée de propagation dans les moyens d'amplification, par conséquent la durée de propagation dans les moyens de comparaison 100 et les moyens de neutralisation 200 n'est pas prise en compte dans la durée de neutralisation égale à la deuxième durée de propagation Tpe de changement d'état de signal de sortie s_{COMP}. En d'autres termes, la deuxième durée de propagation Tpe est égale à la première durée de propagation Tp des signaux dans le comparateur COMP à une tolérance tol près.

La tolérance tol est comprise entre 0 et 5%.

Les moyens de neutralisation 200 sont couplés à l'étage verrou 30.

Le dispositif préamplificateur 1 et le dispositif amplificateur 2 sont incorporés dans des moyens d'amplification connectés entre l'interface d'entrée et les moyens de comparaison 100.

Les moyens d'amplification comportent des amplificateurs opérationnels.

Les moyens de neutralisation 200 comportent un circuit de réplique 18 comprenant une première borne d'entrée A, une seconde borne d'entrée B, une première borne de sortie C et une deuxième borne de sortie D, des moyens d'amplification auxiliaire 21 configurés pour présenter la deuxième durée de propagation Tpe de signaux égale à la première durée de propagation Tp de signaux dans le comparateur COMP en amont des moyens de comparaison 100 et de neutralisation 200 à la tolérance tol près. En d'autre terme la deuxième durée Tpe est égale à la première durée Tp à 5% près.

Les moyens de neutralisation 200 comprennent en outre une porte logique inverseuse 11 comprenant une entrée et une sortie, deux portes logiques NON-ET 14, 15, connues sous la dénomination anglo-saxonne « NAND » et une porte une porte logique NON-OU 17 connue sous la dénomination anglo-saxonne « NOR », comprenant chacune deux entrées et une sortie.

Les moyens de comparaison 100 comportent la bascule 10 couplé à l'interface de sortie par l'intermédiaire d'un multiplexeur 19 comprenant une première entrée E191, une deuxième entrée E192, une entrée de commande Ec19 et une sortie S19 et des portes logiques inverseuses 12 et 13 comprenant chacune une entrée et une sortie, et une porte logiques NON-ET 16 connue sous la dénomination anglo-saxonne « NAND » comprenant deux entrées et une sortie.

L'entrée E301 de l'étage verrou 30 est reliée à l'entrée de la porte inverseuse 11. Une première entrée E171 de la porte 17 et une première entrée E151 de la porte 15 sont reliées à la sortie de la porte 11. La sortie S17 de la porte 17 est reliée à l'entrée S1 du dispositif 10.

La sortie S15 de la porte 15 est reliée à une première entrée E161 de la porte 16 et la sortie S16 de la porte 16 est reliée à l'entrée R1 du dispositif 10.

L'entrée E302 du dispositif de verrouillage 30 est reliée d'une part, à la seconde entrée E162 de la porte 16, et, d'autre part, à une première entrée E141 de la porte 14.

La sortie S14 de la porte 14 est reliée à la deuxième entrée E172 de la porte 17.

La sortie S30 du dispositif de verrouillage 30 est reliée à la sortie de la porte 13. La sortie S19 du multiplexeur 19 est reliée à l'entrée de la porte 13 et à l'entrée de commande Ec19.

La sortie Qbl de la bascule 10 est reliée d'une part, à l'entrée E191 du multiplexeur 19 par l'intermédiaire de la porte inverseuse 12, la sortie de la porte 12 étant reliée à l'entrée E191, et d'autre part, à la borne A du circuit réplique 18.

La sortie Q1 de la bascule 10 est reliée d'une part, à l'entrée E192 du multiplexeur 19, et d'autre part, à la borne B du circuit réplique 18.

La borne C du circuit réplique 18 est reliée à la deuxième entrée E152 de la porte 15, et la borne D des moyens de retard 18 est reliée à la deuxième entrée E142 de la porte 14.

Les moyens de neutralisation 200 comportent le circuit de réplique 18 possédant les bornes d'entrée A et B couplées aux entrées de la bascule 10 et des portes logiques 11, 14, 15 et 17 couplées entre les bornes de sortie D et C du circuit de réplique et les entrées de la bascule S1 et R1.

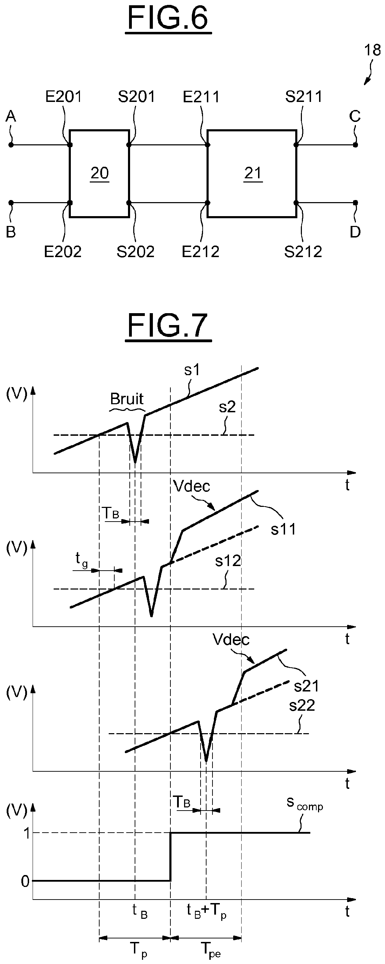

Comme illustrés à la figure 6, le circuit réplique 18 comprend un convertisseur numérique analogique 20 comprenant une première entrée E201 reliée à la borne A et une deuxième entrée E202 reliée à la borne B et deux sorties S201 et S202 reliées respectivement aux entrées E211 et E212 des moyens d'amplification auxiliaire 21 configurés pour présenter la deuxième durée de propagation Tpe de signaux égale à la première durée de propagation Tp à la tolérance tol près. Les moyens 21 comprennent deux sorties S211 et S212 reliées respectivement aux bornes C et D.

Les moyens 21 comprennent des amplificateurs opérationnels auxiliaires fonctionnellement analogues aux amplificateurs opérationnels des dispositifs 1 et 2 à un facteur d'échelle près. En d'autres termes, les amplificateurs opérationnels auxiliaires sont configurés pour présenter la deuxième durée de propagation Tpe identique à la tolérance tol près à la première durée de propagation Tp de signaux à l'intérieur des dispositifs 1 et 2 de façon à être traversés par un courant plus faible que celui traversant le dispositif préamplificateur 1 et le dispositif amplificateur 2. L'homme du métier saura configurer les amplificateurs opérationnels auxiliaires, par exemple en changeant la valeur des résistances des montages inverseurs et/ou en modifiant d'autres paramètres de fonctionnement des amplificateurs opérationnels auxiliaires. Ces paramètres peuvent notamment être déterminés par des simulations numériques à partir d'un modèle numérique du comparateur haute fréquence CHF intégrant l'étage verrou 3.

La diminution du courant traversant les moyens 21 permet de diminuer la consommation électrique et la dissipation de chaleur du circuit réplique 18.

Le convertisseur numérique analogique 20 convertit les signaux numériques reçus sur les bornes A et B en signaux analogiques utilisés par les amplificateurs opérationnels auxiliaires incorporés dans les moyens 21.

Les moyens de neutralisation 200 neutralisent tout changement d'état du signal de sortie s_{COMP} du comparateur COMP à compter de chaque instant de changement d'état du signal de sortie et pendant la seconde durée de propagation Tpe égale à la durée de propagation de signaux à l'intérieur des moyens d'amplification comprenant les dispositifs 1 et 2.

La figure 7 illustre le fonctionnement d'un exemple de comparateur COMP.

On retrouve en entrée du comparateur les signaux s1 et s2, le bruit sur le signal s1 à l'instant t_{B}. Le dispositif d'hystérésis incorporé dans le préamplificateur modifie la sortie S11 du dispositif préamplificateur 1 en ajoutant la valeur d'hystérésis Vdec au signal s1 après le changement d'état du signal de sortie s_{COMP} comme décrit précédemment.

Suite au changement d'état du signal de sortie s_{COMP}, le circuit réplique 18 reçoit à ses entrées A et B le changement d'état des moyens de comparaison 100. Il neutralise toute commande des entrées S1 et R1 des moyens de comparaison 100 pendant la seconde durée de propagation Tpe égale à la durée de propagation des signaux reçus aux entrées A et B dans les moyens 21, en retardant la transmission de la consigne de changement d'état aux portes logiques 11, 14, 15 et 17.

Le bruit sur le signal d'entrée s1 atteint l'entrée des moyens de comparaison 100 à un instant t_{B}+Tp compris dans la seconde durée de propagation Tpe de neutralisation des moyens de comparaison. Par conséquent la sortie du comparateur Scomp ne change pas d'état.

Le circuit réplique 18 ne nécessite pas de signal d'horloge et a une consommation électrique égale à un dixième de celle d'un comparateur connu de l'état de la technique pour une approximation de la première durée de propagation Tp au premier ordre.

## Revendications

1. Procédé de contrôle du fonctionnement d'un comparateur (COMP) comportant des moyens d'amplification connectés en entrée de moyens de comparaison (100), le procédé comportant une neutralisation de tout changement d'état d'un signal de sortie du comparateur à compter de chaque instant de changement d'état du signal de sortie (s_{COMP}) et pendant une deuxième durée de propagation (Tpe) égale à une durée de propagation de signaux à l'intérieur des moyens d'amplification (1, 2).

2. Comparateur (COMP) comprenant une interface d'entrée (E1, Eref) pour recevoir des signaux d'entrée (s1, s2), une interface de sortie (S_{COMP}) pour délivrer un signal de sortie (s_{COMP}), des moyens de comparaison (100) couplés entre l'interface d'entrée et l'interface de sortie, des moyens d'amplification (1,2) connectés entre l'interface d'entrée (E1, Eref) et les moyens de comparaison (100), et des moyens de neutralisation (200) configurés pour neutraliser tout changement d'état du signal de sortie à compter de chaque instant de changement d'état du signal de sortie pendant une deuxième durée de propagation (Tpe) égale à une durée de propagation de signaux à l'intérieur des moyens d'amplification (1, 2).

3. Comparateur selon la revendication 2, dans lequel la seconde durée de propagation (Tpe) est égale à une première durée de propagation (Tp) égale à une durée de propagation de signaux à l'intérieur dudit comparateur (COMP) à une tolérance (tol) près.

4. Comparateur selon la revendication 3, dans lequel la tolérance (tol) est comprise entre 0 et 5%.

5. Comparateur selon l'une quelconque des revendications 2 à 4, dans lequel les moyens de neutralisation (200) comportent un circuit de réplique (18) des moyens d'amplification (1,2) configurés pour présenter ladite deuxième durée de propagation (Tpe).

6. Comparateur selon l'une des revendications 2 et 5, dans lequel les moyens de comparaison (100) comportent un étage verrou (30) couplé à l'interface de sortie (S_{COMP}) et les moyens de neutralisation (200) sont couplés à l'étage verrou (30).

7. Comparateur selon la revendication 6, dans lequel l'étage verrou (30) comporte une bascule (10) couplée à l'interface de sortie (S_{COMP}) par l'intermédiaire d'un multiplexeur (19) et les moyens de neutralisation (200) sont couplés entre les sorties (Qb1, Q1) et les entrées (R1, S1) de la bascule.

8. Comparateur selon l'une des revendications 5 à 7, dans lequel les moyens de neutralisation (200) comportent le circuit de réplique (18) possédant des entrées (C, D) couplées aux entrées (R1, S1) de la bascule (10) et des portes logiques (14, 15, 17) couplées entre des sorties du circuit de réplique (18) et les entrées de la bascule (10).

9. Comparateur selon l'une des revendications 5 à 8, dans lequel les moyens d'amplification (1,2) comportent des amplificateurs opérationnels et le circuit de réplique (18) comporte des amplificateurs opérationnels auxiliaires fonctionnellement analogues aux amplificateurs opérationnels à un facteur d'échelle près.

10. Comparateur selon l'une des revendications 2 à 9, présentant une fréquence de fonctionnement supérieure à 200 MHZ.
